# EUROPEAN PATENT APPLICATION

(11) **EP 2 843 398 A1**
(43) Date of publication of application: **04.03.2015**
(21) Application number: 13397529.2
(22) Date of filing: 02.09.2013
(51) Int. Cl.: G01N 23/225, H01J 37/252, H01J 33/02, H01J 3/02

(54) **Electron source and X-ray fluorescence analyser using an electron source**

(71) Applicant: Fenno-Aurum OY, 02270 Espoo (FI)
(72) Inventor: Sipilä, Heikki, FI-02270 Espoo (FI); Fedkov, Evgeny, St. Petersburg (RU); Serebriakov, Aleksandr, St. Petersburg (RU)
(74) Representative: Berggren Oy Ab

(57) **Abstract**

An electron source of an X-ray fluorescence analyser comprises a photon source (201) and a photoelectric converter (203, 204) for converting photons into electrons. An electron multiplier (203, 204) multiplies the electrons, and a focusing element (206, 207) focuses them to a beam. A gastight casing (209) encloses the photoelectric converter and the electron multiplier (203, 204). An electron-transparent membrane (213) covers a first opening in the casing at a location where the focused electron beam is directed out of said casing.

## Description

### TECHNICAL FIELD

The invention is related to the technical field of X-ray fluorescence analysers, and sources of incident radiation used in X-ray fluorescence analysers. In particular the invention is related to the use of an electron beam as the incident radiation in an X-ray fluorescence analyser.

### BACKGROUND OF THE INVENTION

X-ray fluorescence analysers typically use an X-ray tube as the source of incident radiation. The purpose of the incident radiation is to energize the atoms of the sample material sufficiently so that when relaxation from the energized states occurs, the atoms of the sample material emit fluorescent X-rays at their characteristic energies. The energy spectrum of the incident X-rays produced in an X-ray tube is defined by the acceleration voltage, the anode material, and the filtering and attenuating effect of radiation windows and possible other material layers and media through which the radiation must pass. Conventional X-ray fluorescence analysers are well suited for analyzing the concentration of relatively heavy constituents, such as metals, in a sample. However, due to the relatively deep penetration of incident X-rays into the sample material, they are not well suited for measuring lighter elements, such as carbon, nitrogen, oxygen, fluorine, and sodium.

A prior art publication US 6,452,177 introduces the use of an electron beam as the incident radiation in an X-ray spectrometer. Electrons are produced by heating a filament, accelerated, and focused into a beam with an electromagnetic field inside a vacuum tube. A thin, electron-transparent membrane covering one end of the vacuum tube allows directing the produced electron beam towards a sample, in which the impinging electrons excite atoms of the sample materials and cause them to emit X-rays at characteristic wavelengths.

The apparatus described in said prior art publication has been designed for use on space missions, and would be ill suited for portable or benchtop analysers for various reasons. It consumes a relatively large amount of energy, and yet achieves a limited resolution and measurement reliability.

### SUMMARY OF THE INVENTION

The following presents a simplified summary in order to provide a basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

According to an aspect of the invention there is provided an electron source that can be used as the source of incident radiation in an X-ray fluorescence analyser, and is energy efficient, lightweight, and robust in construction. According to another aspect of the invention there is provided an X-ray fluorescence analyser that utilizes the advantages of such an electron source. According to a further aspect of the invention there is provided an X-ray fluorescence analyser that is capable of measuring concentrations of light elements in a sample. According to yet another aspect of the invention there is provided a method for performing X-ray fluorescence analysis utilising the advantageous features of the electron source and X-ray fluorescence analyser described above.

Advantageous objectives of the invention are achieved by using a photon source to excite a photoelectric converter and multiplying the electrons emitted by the photoelectric converter. The multiplication of electrons can be a built-in feature of the photoelectric converter, if for example one or more multichannel plates are used. The characteristics of the photon source can be selected so that they match the excitation requirements of the photoelectric converter as optimally as possible. For example an ultraviolet-emitting LED can be used as the photon source. The photon source may emit photons in continuous mode or in some timed fashion, for example in short pulses or with an intensity that is modulated over time.

The multiplied electrons are focused into an electron beam, which is directed towards the exposed surface of a sample. In an X-ray fluorescence analyser the sample is typically placed in a sample holder, and a detector is used to detect and measure an energy spectrum of fluorescent X-rays emitted by the sample as a response to being hit by the electron beam.

The photoelectric converter and the electron multiplier are placed inside a gastight casing, inside which vacuum conditions can be set up in order to keep the electrons from being slowed down and attenuated. An electron-transparent membrane covers a first opening in said casing, through which the electron beam is directed towards the sample. The X-ray fluorescence analyser may comprise a dedicated chamber for enclosing the sample and the detector, but since the requirements for avoiding attenuation are less strict for X-rays than electrons, the chamber may have a coarser vacuum (meaning a gaseous atmosphere, the pressure of which is not quite as low) than the inside of the gastight casing of the electron source. Instead of vacuum, a gaseous medium like helium that attenuates X-rays only weakly can be used inside the chamber, at least if the distance that the incident electron beam must travel within the gaseous medium is small.

Compared to a glow filament, which is commonly used as an electron source in X-ray tubes, an electron source of the kind explained above has the advantage of significantly lower energy consumption. In a glow filament a very large majority of the initial energy is dissipated in the form of heat, and only a fraction of the initial energy becomes utilized in the form of accelerated electrons. Photon sources such as gallium nitride LEDs are much more effective in converting the applied electric energy into energy of emitted photons, and while the use of photoelectric conversion and electron multiplication add more steps and corresponding power dissipation factors to the method, the overall efficiency still remains much better than in a glow filament. A further advantage of a photon source over glow filaments is the immensely faster response of a photon source to control signals, which allows accurate timing of incident radiation and consequently very accurate time resolution in measurements.

The novel features which are considered as characteristic of the invention are set forth in particular in the appended claims. The invention itself, however, both as to its construction and its method of operation, together with additional objects and advantages thereof, will be best understood from the following description of specific embodiments when read in connection with the accompanying drawings.

The exemplary embodiments of the invention presented in this patent application are not to be interpreted to pose limitations to the applicability of the appended claims. The verb "to comprise" is used in this patent application as an open limitation that does not exclude the existence of also unrecited features. The features recited in depending claims are mutually freely combinable unless otherwise explicitly stated.
- Fig. 1: illustrates a principle and a method for using photons to create an electron beam,
- fig. 2: illustrates an electron source,
- fig. 3: illustrates a detail of a possible additional feature,
- fig. 4: illustrates an X-ray fluorescence analyser, and
- fig. 5: illustrates a block diagram of an X-ray fluorescence analyser.

### DETAILED DESCRIPTION OF EMBODIMENTS OF THE INVENTION

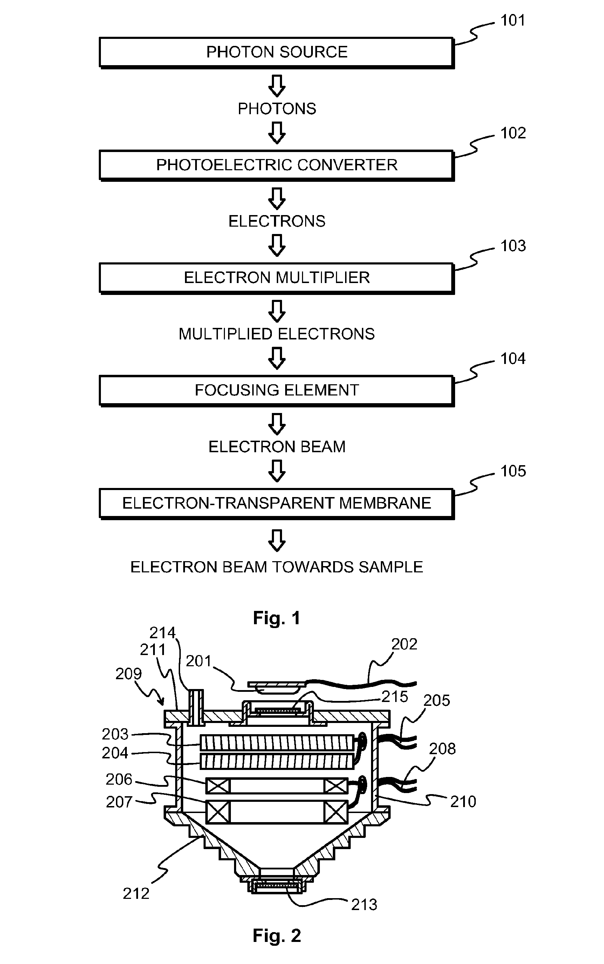

Fig. 1 illustrates a principle of producing a fast electron beam as a part of a method for performing X-ray fluorescence analysis according to an embodiment of the invention. A photon source 101 is used to emit photons towards a photoelectric converter 102, the task of which is - as already the name indicates - to convert photons coming from the photon source 101 into electrons. An electron multiplier 103 multiplies the electrons emitted by the photoelectric converter, typically through secondary emission. The photoelectric converter 102 and the electron multiplier 103 need not be separate devices, but they can be functionalities of the same device, as will be described in more detail later. It is possible, but not necessary, that the photoelectric converter 102 is a separate photocathode.

The multiplied electrons are focused into an electron beam using a focusing element 104. The electron beam is directed towards a sample. Since the generation, multiplication, and focusing of electrons is advantageous to implement in a relatively good vacuum, the directing of the electron beam towards the sample typically takes place through an electron-transparent membrane 105, which seals the evacuated space at the output location of the electron beam.

The method for performing X-ray fluorescence analysis additionally comprises detecting the energy spectrum of fluorescent X-rays that the sample emits as a response to being hit by the electron beam. Aspects of this step of the method will be described in more detail later in association with the description of an X-ray fluorescence analyser according to an embodiment of the invention. The electric current carried by the electron beam may be for example between 1 and 10 microamperes, and the method may comprise scanning the electron beam across an exposed surface of the sample.

Fig. 2 is a schematic cross section of an electron source according to an embodiment of the invention. The direction of emission of the fast electron beam is downwards in the drawing. At the top in the drawing the electron source comprises a photon source 201, which can be any source of photons that have sufficient energy to create photoelectrons. As an example the photon source 201 may be an ultraviolet light-emitting diode (UV-LED) or an array of UV-LEDs. The electric energy necessary to produce the photons in the photon source 201 is conducted thereto through one or more conductors, schematically shown as 202.

In the embodiment of fig. 2 the tasks of converting photons from the photon source into electrons and multiplying the electrons, which were illustrated as 102 and 103 in fig. 1, are fused together. For these purposes the electron source of fig. 2 comprises a common entity, which comprises one or more (here: two) microchannel plates 203 and 204. Photons that come from the photon source 201 enter the channels on the entry side of the first microchannel plate, and cause the primary emission of photoelectrons. A chain of consecutively increasing positive potentials on the face electrodes of the microchannel plates accelerates the electrons downwards, until they hit the walls of the channels and cause secondary emission, which is the mechanism of multiplication. The conductors used to establish the positive potentials are schematically shown as 205.

The primary emission of photoelectrons, i.e. the actual photoelectric conversion, can be enhanced by treating at least the entry side of the first microchannel plate with a substance that efficiently emits electrons when hit by photons of the wavelength of the photon source to be used. As an alternative, a separate photocathode can be placed on the entry side of the first microchannel plate. Some microchannel plates are suitable for use in photoelectric conversion even without any specific treatment, because the activation substance used to plate the pores of these microchannel plates is responsive to both photons and electrons.

Especially when microchannel plates are used for photoelectric conversion and electron multiplication, these tasks are spatially spread over an area that may be larger than the diameter of the desired output beam. The focusing element that is configured to focus electrons coming from the electron multiplier appears as schematically illustrated coils 206 and 207, and the associated conductors 208, in fig. 2.

Electrons are relatively easily attenuated in any elongated passages through a medium. In order to keep the created, multiplied, and focused electrons from attenuating it is advantageous to perform these tasks in a relatively good vacuum. For this purpose at least the photoelectric converter and the electron multiplier 203 and 204 are enclosed in a gastight casing 209. In the embodiment of fig. 2 the coils 206 and 207 that implement the focusing element are also inside the gastight casing 209, but they could also be located outside it, taken that the material of the casing allows electromagnetic fields to penetrate it to an extent large enough to allow meaningful focusing. In the embodiment of fig. 2 the casing comprises a cylindrical metallic body 210 with ceramic end caps 211 and 212. The casing could equally well be made completely of metal, or completely of ceramic material(s). An electron-transparent membrane 213 covers the opening, which may be called the first opening, in the casing 209 at the location wherein the focused electrons are directed out of the casing. A pipe fitting 214 is schematically shown as means for enabling the provision of vacuum conditions inside the casing 209.

Photons experience relatively little attenuation in air or other gaseous media, at least on the wavelengths that are useful for creating photoelectrons. This means that the generation of, and directing towards the photoelectric converter, of photons does not necessarily need to take place in vacuum conditions. In the embodiment of fig. 2 the photon source 201 is located outside the casing 209, and a photon-transparent window 215 covers a second opening in the casing at a location where photons from the photon source 201 are directed into the casing 209. Advantageous materials that can be used in the photon-transparent window 215 include, but are not limited to, magnesium difluoride and silicon dioxide. Advantageous materials that can be used in the electron-transparent membrane 213 in the first opening include, but are not limited to, silicon nitride and beryllium. The thickness of the electron-transparent membrane 213 may be for example in the order of 100 - 500 nanometres.

If the electron-transparent membrane 213 and/or a frame to which it is attached exhibit sufficient electric conductivity, one or both of them may be used as an additional acceleration electrode for the electron beam by coupling it or them to a suitable electric potential. Structures related to the electron-transparent window 213, such as the window frame or holder for example, may also have some function related to the focusing of the electron beam, if their shape and electric potential are such that a suitable electromagnetic field is formed.

In some cases it may be advantageous if the electron beam can be controllably deflected, in addition to being focused. Such a case occurs for example if a significantly larger area of the surface of a sample needs to be examined than what the focal spot of the electron beam covers. Scanning the electron beam across the surface of the sample could naturally be implemented by physically moving the electron source, the sample, or both. Another possibility is to make the electron source comprise an electron beam deflector configured to controllably deflect electrons focused by the focusing element. Electron beams were routinely deflected with electromagnetic fields in e.g. CRT (cathode-ray tube) displays, so the technology and a multitude of technical implementations of electron beam deflectors is widely known. In the electron source that is schematically shown in fig. 2, the electron beam deflector may comprise e.g. one or more of the coils that are schematically shown as 206 and 207. Same physical element may act both as a focusing element and an electron beam deflector, or there may be separate, dedicated physical elements for these functions.

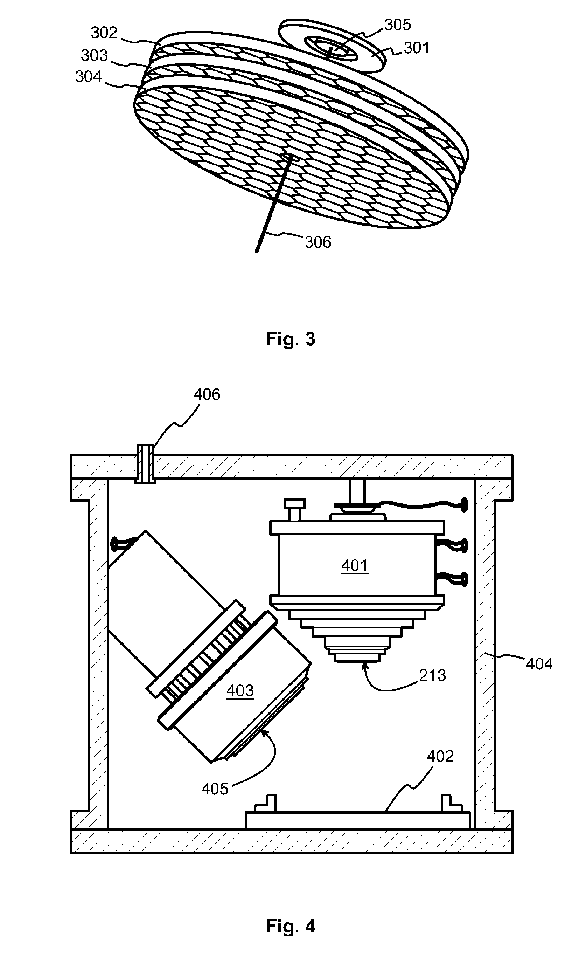

Fig. 3 illustrates parts of an electron source in which the generation of an electron beam is combined with a visual indication of the irradiated spot. In the embodiment of fig. 3 the photon source 301 has annular form. It may comprise a suitably shaped monolithic LED chip or a circular array of a number of separate LED chips. The photoelectric converter comprises three stacked microchannel plates 302, 303, and 304. Each of these has a hole in the middle. A laser diode 305 is located in the middle of the annularly shaped photon source 301 so that it can emit a laser beam 306 through the holes in the microchannel plates 302, 303, and 304. A focusing element (not shown in fig. 3) is configured to focus the accelerated electrons that come out of the stack of microchannel plates 302, 303, and 304 so that the focal point of the electron beam is on the path of the laser beam 306.

If the photon source itself is capable of producing light on a visible wavelength, a visual indication may be provided with a configuration simpler than that of fig. 3. It suffices to have coaxial holes through the whole photoelectric converter and electron multiplier arrangements (for example: through all microchannel plates). While all other photons emitted by the photon source are utilized for the photoelectric conversion, those that pass through the holes provide a visual indication on the sample in the form of a beam of light.

The visual indication provided by a laser beam or a beam of light may be useful if the irradiated spot on the sample surface must be selected very carefully. Depending on the structure and operation of the focusing element it may be possible to irradiate even a very small portion of the sample surface with the electron beam, in which case the visual indication may provide a useful aiming aid. A tightly focused electron beam may allow e.g. in analyzing the short-range differences in the constitution of a somewhat heterogeneous sample. On other hand, not focusing the electron beam too tightly may be advantageous if the granularity or other heterogeneity of the sample surface is not an issue, and/or if the aim is to produce more fluorescent X-rays by irradiating a larger portion of the sample surface with the electron beam. The irradiated area on the sample surface may be for example a couple of square millimetres.

Fig. 4 is a schematic cross section that illustrates an X-ray fluorescence analyser according to an embodiment of the invention, comprising an electron source 401 of the kind described above. The X-ray fluorescence analyser comprises a sample holder 402 that is configured to hold a sample (not shown in fig. 4) at a location to which an electron beam would come through the respective first opening in the electron source 401. An X-ray detector 403 is configured to receive X-rays that will be generated in a sample, when sample is held by the sample holder 402 and irradiated with an electron beam coming from the electron source 401. A chamber 404 encloses at least the space between a sample held by the sample holder 402 and an entrance window 405 of the X-ray detector 403.

The chamber 404 allows controlling the atmosphere between at least the sample and the entrance window 405 of the detector 403 so that the fluorescent X-rays generated in the sample would experience as little attenuation as possible before they enter the detector 403. If the electron beam that is used as the incident radiation had to travel through air at room pressure, it would experience heavy attenuation, so it is advantageous if the chamber 404 encloses also the space between the electron-transparent window 213 of the electron source 401 and a sample held by the sample holder 402. It is also possible to use two separate chambers: one on the path of the incident radiation and the other on the path of the fluorescent X-rays.

An atmosphere control subsystem should be available for controlling the atmosphere inside the chamber 404. In its simplest form the atmosphere control subsystem that is comprised by the X-ray fluorescence analyser itself need not be more than a gas flushing joint 406, through which the chamber may be pumped empty and/or flushed with helium or other suitable gaseous medium that causes only little attenuation. It is also possible that the X-ray fluorescence analyser is made independent of all external equipment in this respect by equipping it with a vacuum pump and/or a pressurized purging gas container of its own.

An advantageous detector for use as the detector 403 in an X-ray fluorescence analyser according to an embodiment of the invention is a silicon drift detector (SDD). Its entrance window 405 may comprise a layer of silicon nitride, which has a thickness as small as 40 - 100 nm, as a continuous window layer. Radiation window foils that have such an extremely thin silicon nitride layer, as well as methods for their manufacturing, are known for example from the patent application PCT/F12012/050804, which at the time of writing this description is not yet available to the public. A PIN detector could also be used, but an SDD is believed to have better noise characteristics especially at the low characteristic energies of light elements that can be measured with an X-ray fluorescence analyser according to an embodiment of the invention. Using an electron beam as the incident radiation allows exciting, and measuring the characteristic fluorescent X-ray peaks of light elements such as carbon, nitrogen, oxygen, fluorine, and sodium, with relatively high efficiency even with relatively small excitation current values. In an advantageous embodiment of the invention, the electric current carried by the electron beam is between 1 and 10 microamperes.

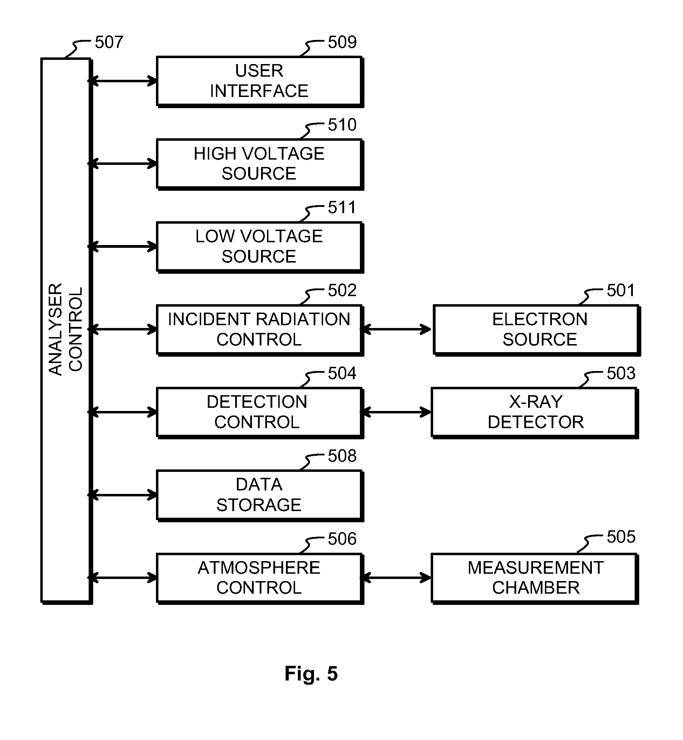

Fig. 5 is a schematic functional block diagram of an X-ray fluorescence analyser according to an embodiment of the invention. The electron source 501 is one where photons emitted by a photon source are converted into electrons through photoelectric conversion, multiplied in an electron multiplier, and focused into an electron beam that can be directed towards a sample. An incident radiation control functionality 502 is responsible for controlling the electron source, for example for controllably switching the electron source on and off and/or controlling the intensity of the electron beam, and for scanning the electron beam if the electron source 501 comprises an electron beam deflector. The X-ray detector 503 is for example an SDD or a PIN detector, and its operation (biasing, readout, clearing etc.) is controlled by a detection control functionality 504.

The X-ray fluorescence analyser of fig. 5 comprises a measurement chamber 505 that encloses at least the space between the sample and an entrance window of the X-ray detector 503. The chamber 505 may enclose also the space between an electron-transparent membrane at the output of the electron source 501 and the sample. An atmosphere control subsystem 506 is provided for controlling the atmosphere inside the measurement chamber 505.

An analyser control functionality 507 is responsible for the overall operation of the X-ray fluorescence analyser, and comprises typically a computer. It has a data storage 508 at its disposal for storing the measurement data obtained through the detection control functionality 504 from the X-ray detector 503, and also for storing the machine-readable instructions that, when executed by the computer in the analyser control functionality 507, cause the implementation of a method for performing X-ray fluorescence analysis according to the invention. The analyser control functionality 507 is also coupled to a user interface 509, which may comprise various indicator means such as one or more displays and various input means such as keys or touchscreens, for enabling bidirectional communications with a human user.

Other functionalities of the X-ray fluorescence analyser illustrated in fig. 5 are a high-voltage source for generating and distributing the high voltages that are needed for biasing in the electron source 501 and the X-ray detector 503, and a low voltage source 511 for generating and distributing the operating voltages of all other functional blocks in the X-ray fluorescence analyser.

Blocks 502, 504, and 506 to 511 of Fig. 5 can also be read as an illustration of the functional division of the machine-readable instructions mentioned above.

The emission of photons from a photon source can be controlled over time in a relatively accurate manner, for example so that the emission of photons takes place in pulses. A LED emits photons as a response to the electric current flowing through it, so if a LED is used as the photon source, the emission of photons can be modulated by modulating the current. Another example of a time-controlled photon source is a pulsed laser, in which Q-switching, mode-locking, or pulsed pumping causes the optical energy to be output in the form of short pulses rather than continuously. Focusing a pulsed laser to a small spot may easily create energy densities large enough to vaporize the material that is hit by the photons, so using a pulsed laser as a photon source in an embodiment of the invention may require using a beam expander or otherwise taking care that the output of the laser becomes distributed over a large enough area of the photoelectric converter.

The operation of an electron source according to an embodiment of the invention (i.e. the photoelectric conversion, the multiplication of electrons, and the forming of an electron beam) takes place with very little additional delay. Thus the intensity of the electron beam hitting the target will follow very accurately any possible modulation over time of the photon emission. Even the creation of X-ray fluorescence in the sample and the detection of the fluorescent X-rays introduce very little additional delay. This means that an X-ray fluorescence analyser according to an embodiment of the invention may be capable of analyzing even very fast dynamic changes in the sample, contrary to prior art X-ray fluorescence analysers where the electron source comprised a glow filament and a high acceleration voltage.

Implementing dynamic measurements in an apparatus of the kind that is schematically illustrated in fig. 5 requires that the electron source 501 comprises a photon source that is capable of time-dependent emission of photons, and that the incident radiation control functionality 502 is capable of controlling the time-dependent emission of photons, for example by providing a time-dependent current or other kind of control signal(s) to the photon source. Additionally the detection control functionality 504 must be configured to utilize the resulting time-dependent X-ray fluorescence, for example by regularly timestamping stored detection results so that later it is possible to correlate a particular X-ray fluorescence measurement with the appropriate moment in time.

Variations and modifications to the features described above are possible. For example, although the description above has mentioned a photon source as the device that is used to initiate photoelectric conversion and electron multiplication, it would be possible to use a piece of a β⁻-decaying radioactive substance such as ⁶³Ni instead. A β⁻-decaying radioactive substance produces electrons that are then received by and multiplied in the electron multiplier, making a photoelectric converter unnecessary. However, since the emission levels from a photon source such as an UV-LED are much easier to control, the use of a photon source and a photoelectric converter makes an electron source and an X-ray fluorescence analyser more practical to operate. The use of a β⁻-decaying radioactive substance could mainly apply to space applications, where the consumption of electric current should be kept at an absolute minimum.

## Claims

1. An electron source for generating an incident electron beam for a measurement device, comprising:
- a photon source,
- a photoelectric converter configured to convert photons from said photon source into electrons,
- an electron multiplier configured to multiply electrons coming from said photoelectric converter,
- a focusing element configured to focus electrons coming from said electron multiplier,
- a gastight casing that encloses at least said photoelectric converter and said electron multiplier, and
- an electron-transparent membrane that covers a first opening in said casing at a location where focused electrons are directed out of said casing.

2. An electron source according to claim 1, wherein said photon source is a light-emitting diode.

3. An electron source according to claim 2, wherein said light-emitting diode is an ultraviolet light-emitting diode.

4. An electron source according to any preceding claim, wherein:
- said photon source is located outside said casing, and
- a photon-transparent window covers a second opening in said casing at a location where photons from said photon source are directed into said casing.

5. An electron source according to claim 4, wherein said photon-transparent window comprises at least one of the following materials: magnesium difluoride, silicon dioxide.

6. An electron source according to any preceding claim, wherein said photoelectric converter and said electron multiplier are implemented in a common entity that comprises one or more microchannel plates.

7. An electron source according to any preceding claim, comprising an electron beam deflector configured to controllably deflect electrons focused by said focusing element.

8. An electron source according to any preceding claim, wherein said electron-transparent membrane comprises silicon nitride.

9. An electron source according to any preceding claim, comprising vacuum conditions inside said casing.

10. An X-ray fluorescence analyser comprising an electron source according to claim 1.

11. An X-ray fluorescence analyser according to claim 10, comprising:
- a sample holder configured to hold a sample at a location to which an electron beam comes through said first opening,
- an X-ray detector configured to receive X-rays generated in a sample, when such a sample is held by said sample holder,
- a chamber enclosing the space between said sample and an entrance window of said X-ray detector, and
- an atmosphere control subsystem for controlling the atmosphere inside said chamber.

12. An X-ray fluorescence analyser according to claim 11, wherein said atmosphere control subsystem comprises at least one of the following: a vacuum pump, a gas flushing joint.

13. An X-ray fluorescence analyser according to claim 11 or 12, wherein said X-ray detector is a silicon drift detector, and said entrance window comprises a layer of silicon nitride, the thickness of which is between 40 and 100 nanometres.

14. A method for performing X-ray fluorescence analysis, comprising:
- emitting photons towards a photoelectric converter,
- multiplying electrons emitted by said photoelectric converter,
- focusing the multiplied electrons into an electron beam,
- directing said electron beam to a sample, and
- detecting an energy spectrum of fluorescent X-rays emitted by said sample as a response to being hit by said electron beam.

15. A method according to claim 14, wherein the electric current carried by said electron beam is between 1 and 10 microamperes.

16. A method according to claim 14 or 15, comprising scanning said electron beam across an exposed surface of said sample.

17. A method according to any of claims 14 to 16, wherein said emission of photons takes place in pulses.
